# EUROPEAN PATENT SPECIFICATION

(11) **EP 3 360 392 B1**
(45) Date of publication and mention of the grant of the patent: **26.02.2020**
(21) Application number: 16854455.9
(22) Date of filing: 07.10.2016
(51) Int. Cl.: H05B 37/02, H05B 39/04, H05B 41/36, F21V 31/04, F21S 4/22, F21K 9/64, H05B 33/08, H01L 33/48, F21V 23/06, F21V 3/02, H01L 33/50, F21Y 115/10, F21Y 103/10, F21W 107/00

(54) **FLEXIBLE LED LIGHTING ELEMENT**
FLEXIBLES LED-BELEUCHTUNGSELEMENT
ÉLÉMENT D'ÉCLAIRAGE À DEL FLEXIBLE

(30) Priority: 07.10.2015 US 201514877534
(43) Date of publication of application: 15.08.2018
(60) Divisional application: 19179194.6
(73) Proprietor: B/E Aerospace, Inc., Wellington, FL 33414 (US)
(72) Inventor: JOHANNESSEN, Eric, Holbrook, NY 11741 (US); TODZIA, Jonathan, Farmingville, NY 11738 (US); LASALA, Donald, Seaford, NY 11783 (US); GAMBESKI, Gannon, T., St. James, NY 11780 (US); DUNN, Matthew, Stony Brook, NY 11790 (US); SAM, Luis, South Setauket, NY 11720 (US)
(74) Representative: Marles, Alan David
(86) International application number: PCT/US2016/056069
(87) International publication number: WO 2017/062817

(56) References cited:
- WO-A1-2006/081707
- WO-A1-2011/110217
- WO-A1-2014/026976
- KR-A- 20040 066 650
- US-A- 4 885 430
- US-A1- 2006 237 636
- US-A1- 2010 008 090
- US-A1- 2012 013 252
- US-A1- 2013 300 282
- US-A1- 2015 092 429
- US-A1- 2015 230 315
- US-B2- 6 521 915
- US-B2- 7 850 341

## Description

### CROSS REFERENCE TO RELATED APPLICATIONS

This application claims the benefit of U.S. Provisional Patent Application Serial No. 62/173,855, filed June 10, 2015.

The present application is also a continuation-in-part of U.S. Patent Application No. 14/697,273, filed April 27, 2015, which is a continuation of U.S. Patent Application No. 13/650,289 filed October 12, 2012, now U.S. Patent No. 9,018,853, which claims benefit of U.S. Provisional Application No. 61/546,259 filed October 12, 2011, and which is a continuation-in-part of U.S. Patent Application No. 13/035,329 filed February 25, 2011, now U.S. Patent No. 9,018,858, which claims benefit of U.S. Provisional Application Nos. 61/345,378 filed May 17, 2010, 61/320,545 filed April 2, 2010, and 61/308,171 filed February 25, 2010, and which is a continuation-in-part of U.S. Patent Application No. 12/566,146 filed on September 24, 2009, now U.S. Patent No. 8,378,595, which claims benefit of U.S. Provisional Application Nos. 61/105,506 filed October 15, 2008, and 61/099,713 filed September 24, 2008.

### BACKGROUND

Described herein is a flexible LED lighting element that includes a flexible housing and flexible PCB to which LED units are mounted. An encapsulant fills a channel of the flexible housing and has a same or similar optical refractive index value as is used in the LED unit to hold phosphorous particles used for coloring of the LED. Use of the encapsulant changes the color of the light ultimately emitted from the flexible LED lighting module, and this factor is corrected for in calibration processes associated with the flexible LED lighting module.

Document WO 2011/110217 A1 discloses a light strip comprising metallic wires to provide increased mechanical robustness to the light strip. Document US 2013/0300282 discloses an LED module and illumination device comprising a sealing member with multiple phosphors.

### SUMMARY

Disclosed herein is a flexible LED lighting element according to claim 1.

### DESCRIPTION OF THE DRAWINGS

Various embodiments of the intention are illustrated in the following drawings, in which:
- Figure 1: is a pictorial side view of an embodiment of a flexible LED module assembly;
- Figure 2: is a side view illustrating a bending radius of the module assembly;
- Figure 3: is a cross-sectional view along a longitudinal axis of the module assembly;
- Figure 4A: is a perspective view of the module assembly;
- Figure 4B: is a plan view of the module assembly;
- Figure 4C: is a detail plan view of the module assembly;
- Figure 4D: is a cross-sectional view along the longitudinal axis of the module assembly;
- Figure 4E: is a cross-sectional detail view along the longitudinal axis of the module assembly;
- Figure 5A: is a pictorial side view of an embodiment of a flex LED unit showing emitted light rays without reflection;
- Figure 5B: is a pictorial side view of the flex LED unit showing emitted light rays with reflection but with no surrounding encapsulent;
- Figure 5C: is a pictorial side view of the flex LED unit showing emitted light rays with reflection with surrounding encapsulent having a refractive coefficient similar to that used for the LED unit;
- Figure 6: is a graph that illustrates the impact on the emitted spectrum that the use of the flex encapsulant creates;
- Figure 7: is a CIE chromaticity diagram illustrating the effect of encapsulating the diodes;
- Figure 8A: is a perspective view of a further embodiment of a flexible LED module assembly;
- Figure 8B: is a close-up perspective view of the boxed region in Figure 8A showing a left end of the flexible LED module assembly;
- Figure 8C: is a close-up perspective view showing a right end of the flexible LED module assembly;
- Figure 9: is a perspective view of a diffuser;
- Figure 10: is a cross-sectional view down a longitudinal axis of the embodiment shown in Figure 8A;
- Figure 11A: is a perspective cutaway view illustrating the various components of the embodiment shown in Figure 8A;
- Figure 11B: is a zoomed perspective view of the boxed portion in Figure 11A illustrating the interface of the diffuser; and
- Figure 12: is a plan view of a flexible connector element.

### DETAILED DESCRIPTION

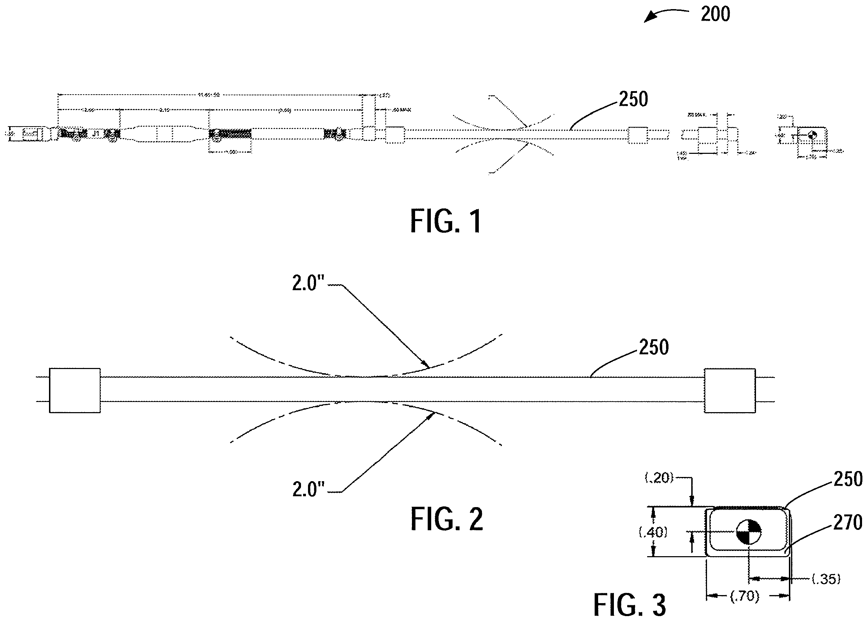

Figure 1 is a pictorial side view of an embodiment of a flexible (flex) LED module assembly 200. This assembly 200 comprises a flexible LED module 250 along with supporting cables, connectors, and the like. Figure 2 illustrates a bending radius for the LED module 250 as being approximately 2.0" in a direction along a U-shaped channel of the module 250 in other words, the upper arms of the U are upright and pointing towards the top in Figure 2. The flexible nature of the LED module 250 is due to the use of a flexible PCB with flexible traces on it, combined with a flexible housing 270. Figure 3 is a cross-section of the module 250 and shows the flexible housing 270 along with example dimensions (inches).

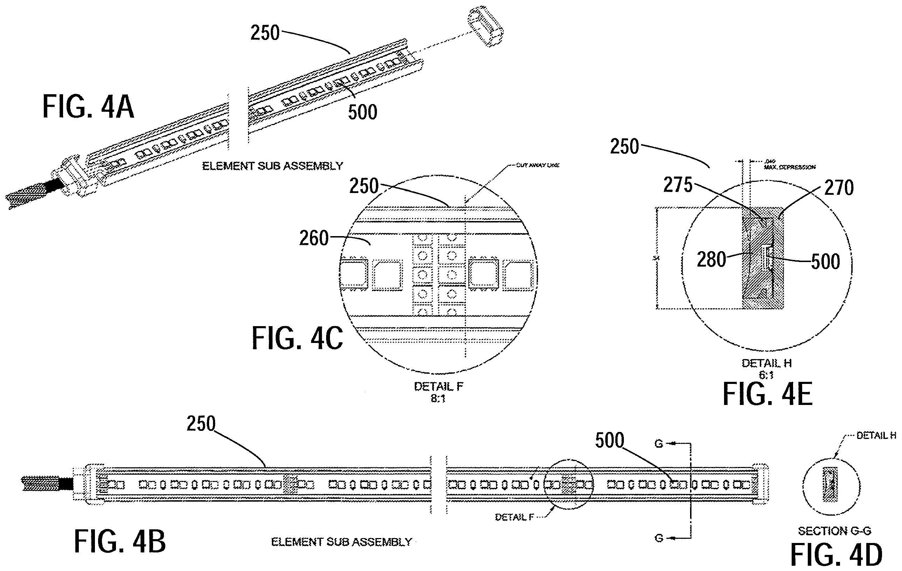

Figure 4A is a perspective view and Figure 4B is a plan view showing in more detail the LED module 250 with a plurality of LED units 500 on them. Figure 4C is a plan detail view showing the circuitry mounted on a flexible PCB 260 of the LED module 250. The LEDs 500 in the module 250 may be densely spaced, e.g., on 0.5" intervals, in order to maximize the amount of light output.

Figure 4D is a cross-section G-G of the LED module 250 shown in Figure 4B, and Figure 4E is a detail view of this cross-section. The flexible housing 270 is shown in more detail and may or may not comprise protrusions 275 in the side walls that hold in a flexible encapsulant 280 that may be based on, e.g., silicone. The flexible housing 270 is made of a flexible material, such as a known thermally conductive silicone. At a bottom portion of the housing's 270 U-shaped channel is the actual LED 500 itself.

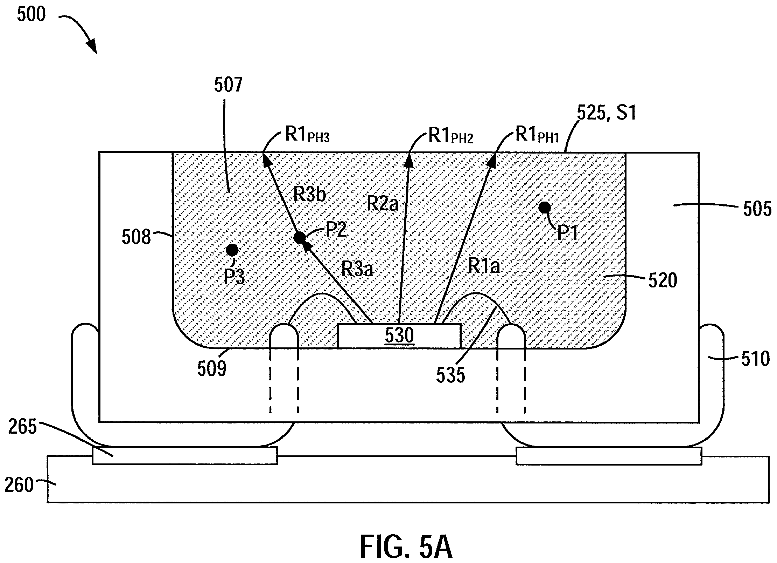

Figure 5A is a more detailed cross-sectional view of Figure 4E, which shows that annealed heavy copper traces 265 may be used in the PCB 260, where this construction provides greater flexibility. In a typical layering for a flexible PCB, there is the laminate layer, then directly above that is a copper foil layer, and then above that is a plated copper layer, and then above that the tin or tin/lead layer. It has been determined that in order to afford the most flexibility, only a single raw annealed heavy copper layer 265 is used above the laminate layer, e.g., a 4 oz/ft² (a foil designation of 4, according to Table 1 below), since the addition of plating can cause the copper layer to be more brittle. Although the annealed heavy copper trace it is more costly than the foil layer with copper plating, the flexibility characteristics are greater. This is particularly true when the PCB 260 is coated on both sides, as is done in an embodiment. The use of the heavy single copper layer in combination with the use of extremely efficient LEDs permits a length of the flexible PCB to be as much as forty feet.

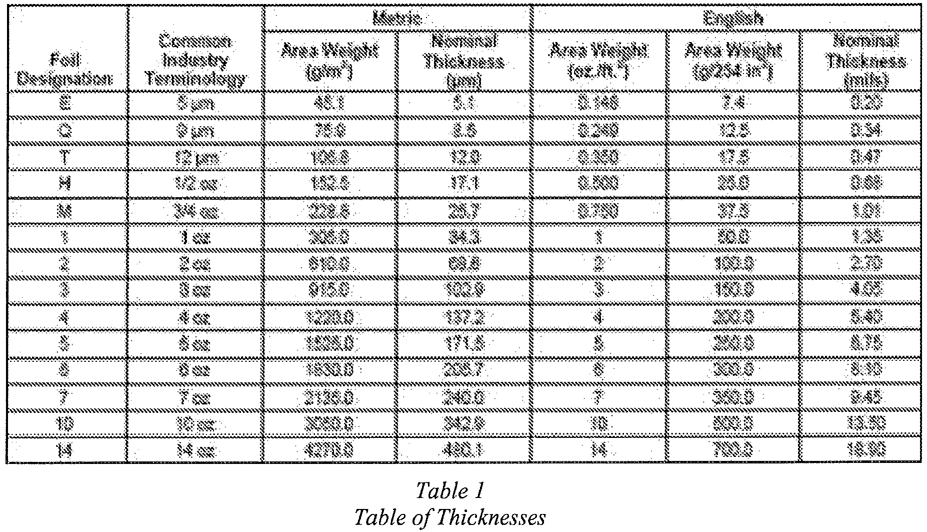

IPC Recommended Track Width For 1 oz cooper PCB and 10 °C Temperature Rise

**Table 2 Track Widths**

| Current/A | Track Width(mil) | Track Width(mm) |
|---|---|---|
| 1 | 10 | 0.25 |
| 2 | 30 | 0.76 |
| 3 | 50 | 1.27 |
| 4 | 80 | 2.03 |
| 5 | 110 | 2.79 |
| 6 | 150 | 3.81 |
| 7 | 180 | 4.57 |
| 8 | 220 | 5.59 |
| 9 | 260 | 6.60 |
| 10 | 300 | 7.62 |

One of the problems encountered with the flexible design disclosed herein is that the LED flex modules 250 emit a bluer light than the non-flex counterpart that must be adjusted for. This is due to the flex encapsulant 280 that is introduced into the channel of the housing 270. The reason for this is the following.

Figure 5A shows an LED unit 500 in cross-section. This unit 500 comprises a housing 505 (also U-shaped in cross-section) having a cavity 507. The cavity 507 comprises a wall 508 and floor 509. An LED unit connector 510, which is, e.g., a PCB surface mount connector, is used to mount the LED unit 500 to a PCB of the module 250 and contacts the copper trace 265 of the PCB 260. These unit connectors 510 connect with an LED 530 via internal connectors 535. Within the U-shaped cavity 507 is an encapsulant 520 that holds a number of phosphorous particles PI, P2, P3 having different colors this is what allows the creation of a white LED unit and an adjustment of the emitted color for the reasons explained below.

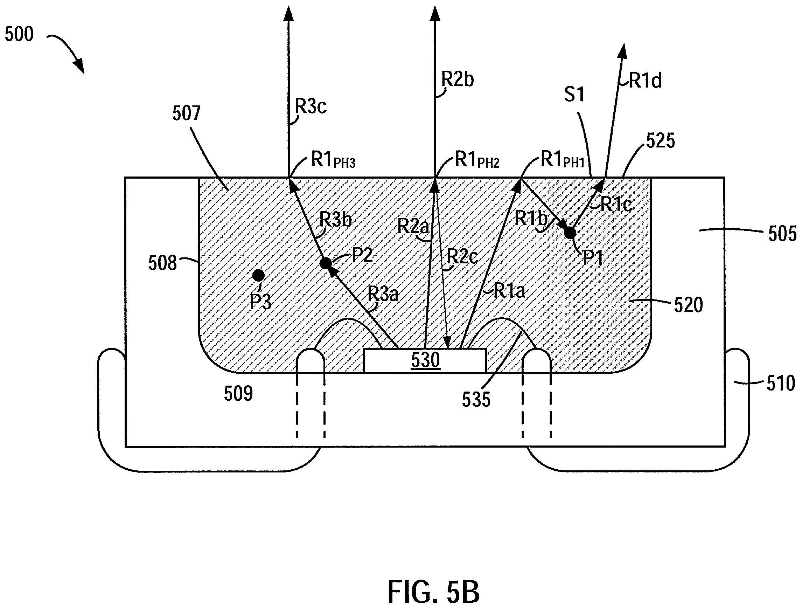

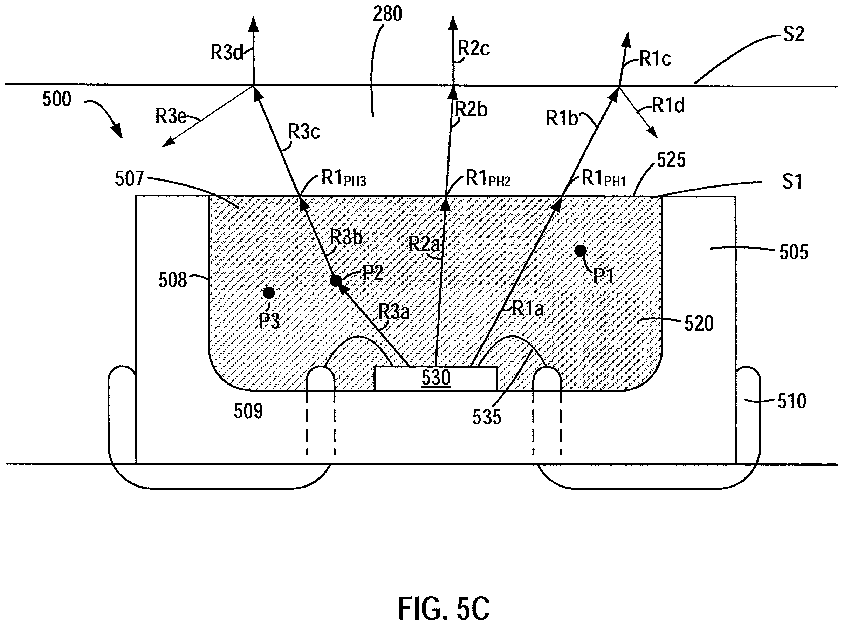

Relatively high-energy blue-colored photons/rays R1a, R2a, R3a are emitted from the LED. In Figure 5A, three colored phosphorous particles P1, P2, and P3 are shown. These particles can include particles that emit blue, red, yellow, and orange colored light and are distributed throughout the LED encapsulant 520. In Figure 5A, only one of the light rays (R3a) interacts with one of the particles (P2). When the high energy ray R3a interacts with the particle P2, a lower energy colored ray R3b is emitted, and the emission can be in any random direction since this is due to an energy state change the difference in energy is known as the Stokes' shift. Figure 5A only shows the rays en route to the surface (S1) 525 of the LED unit 500. Figure 5B illustrates what happens to the rays after contact with the surface 525 without the flex encapsulant 280, and Figure 5C illustrates what happens to the rays after contact with the surface S1 with the flex encapsulant 280.

In Figure 5B, when originating light ray R1a hits the surface 525, it is completely reflected back into the LED encapsulant 520 in a light ray R1b, which strikes a phosphorous particle P1 and emits a different colored ray R1c which then exits the LED unit as another ray R1d. Thus, the original ray R1a which would have had the bluish color of the LED were it not for the reflection at the surface 525, now has, e.g., a red color, due to the reflection from the surface 525. The originating Ray R3a, as described above with respect to Figure 5A is not changed, since it has already directly interacted with the particle P2, and exits the LED unit in a ray R3c, which is, e.g., green in color.

Figure 5C illustrates the situation in which the flex encapsulant 280 is present. Since the flex encapsulant 280 is made of the same or similar flexible material (e.g., silicone) (absent the phosphorous particles, although, in an embodiment, phosphorous particles may also be included in the flex encapsulant 280) as the LED encapsulant 520, non-interacting original LED light rays (e.g., R1a) that would have reflected back into the phosphorous embedded LED encapsulant 520 and gotten a second chance to interact with a particle (e.g., P1) are instead directed out of the LED unit (R1b), since the index of refraction of the two materials (flex encapsulant 280 and LED encapsulant 520) is the same. Since rays that would have been reflected but are not due to the presence of the flex encapsulant 280 now exit the LED module 250 at the surface S2, the emitted light takes on a bluer color, which must be accounted for.

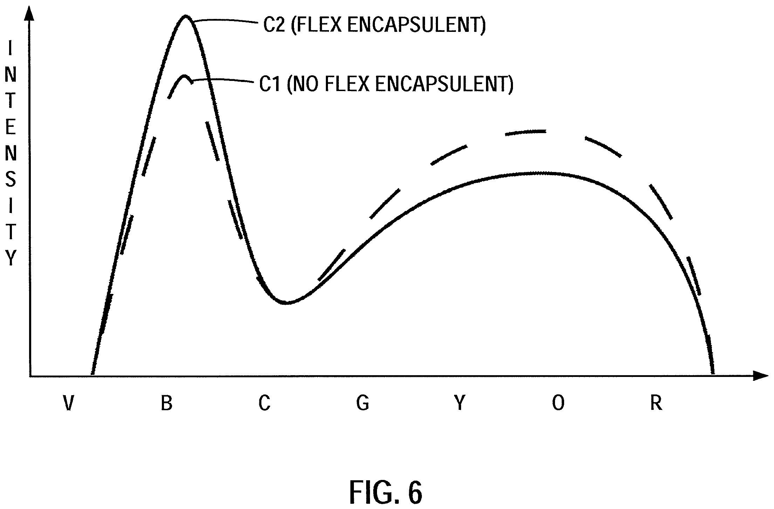

Figure 6 is a graph that illustrates the impact on the emitted spectrum that use of the flex encapsulant 280 creates, with C1 being the intensity v. frequency curve when there is no flex encapsulant 280, and C2 being the curve when the flex encapsulant 280 is present.

Calibration procedures, such as those disclosed in U.S. Patent Publication No. 2012 0013252, may be utilized in calibrating the LED module 250.

However, in order to properly calibrate the flex LED module 250, the color shift caused by the flex encapsulant 280 must be taken into account for a warm white LED, the color shift may be, e.g., 900 °K, whereas for a cool white LED, the color shift may be 1200 °K. Thus, an adjustment factor must be included into the calibration process. The adjustment factor and calibration process can also compensate for LED intensity changes, color of the PCB mask (e.g., a white solder mask), a color shift from thermal effects, and varying flex encapsulant 280 thickness.

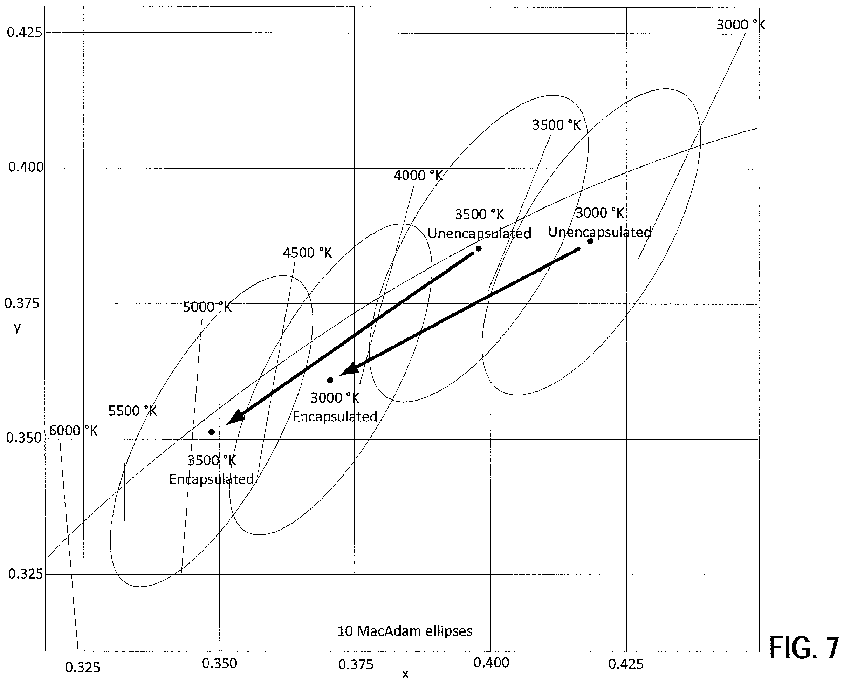

Figure 7 is a graph of a portion of a CIE chromaticity diagram illustrating the color shifts created by use of the encapsulent for both 3000 °K and 3500 °K LEDs. As can be seen, the use of the encapsulant shifts, in both instances, the color towards a more blue (hotter) color temperature. The following table provides example data upon which the Figure 7 graph is based. The LED shift vs. its initial condition of the color temperature is non-linear, meaning that the shift is greater for cooler LEDs, and thus, this non-linear aspect should be taken into consideration in determining the adjustment factor.

**Table 3 Color Shifts for Encapsulated vs. Unencapsulated LEDs**

| | **3500K LED** | | | **3000K LED** | |
|---|---|---|---|---|---|
| | **Unencapsulated** | | **Encapsulated** | **Unencapsulated** | **Encapsulated** |
| **x** | 0.398 | | 0.3485 | 0.4185 | 0.3705 |
| **y** | 0.3852 | | 0.3512 | 0.3866 | 0.3609 |
| **CCT** | 3620K | | 4869K | 3182K | 4172K |
| **Shift Magnitude** | | 0.0601 | | 0.0544 | |
| **Shift Angle** | | -34 | | -28 | |

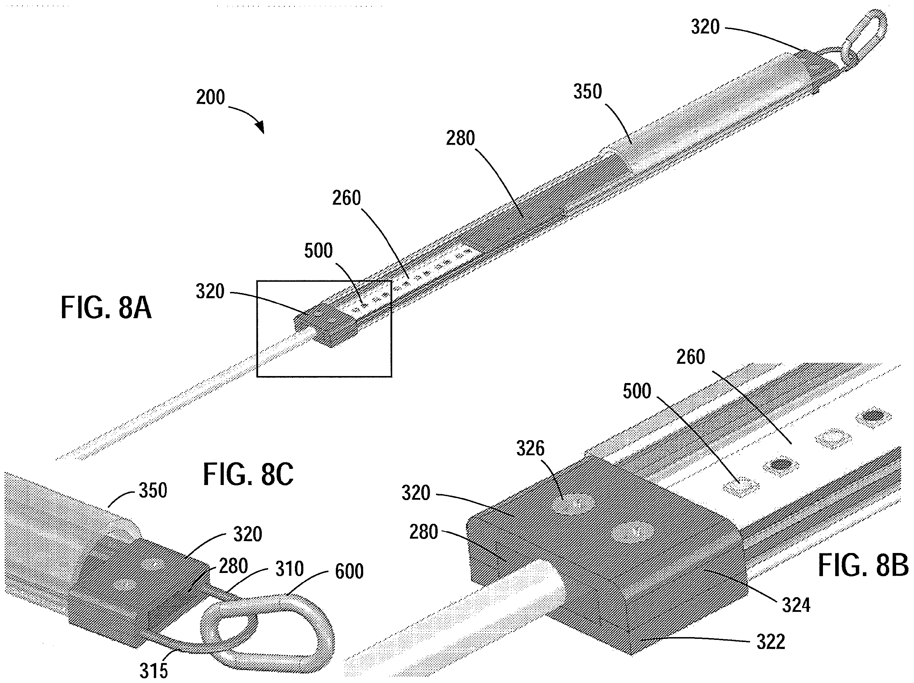

Figure 8A is a perspective view of a further embodiment of a flexible LED module assembly 200. This embodiment illustrates a particular form of end caps 320 and diffuser 350. These features are illustrated in more detail in Figures 8B and 8C. In Figure 8B, the end cap 320 has a bottom 322 and top 324 portion that are held together with fasteners 326 such as screws. These fasteners 326 also serve to fix the flex LED module 250 and flexible PCB 260 to the end cap 320 as well. An electrical cable (not numbered) enters the end cap 320 on one side, and is surrounded by a flex encapsulent 280 which may be the same flex encapsulent 280 that fills the assembly 200, or it could be comprised of a different material that has at least one of a flexible property and a sealing property. In Figure 8C, the end cap 320 can be seen with two reinforcing rods 310 (discussed in more detail below) protruding from the end with a connection loop 315 joining the reinforcing rods, forming a loop through which, e.g., a lanyard 600 may be extended for fixing the assembly 200 to a particular location.

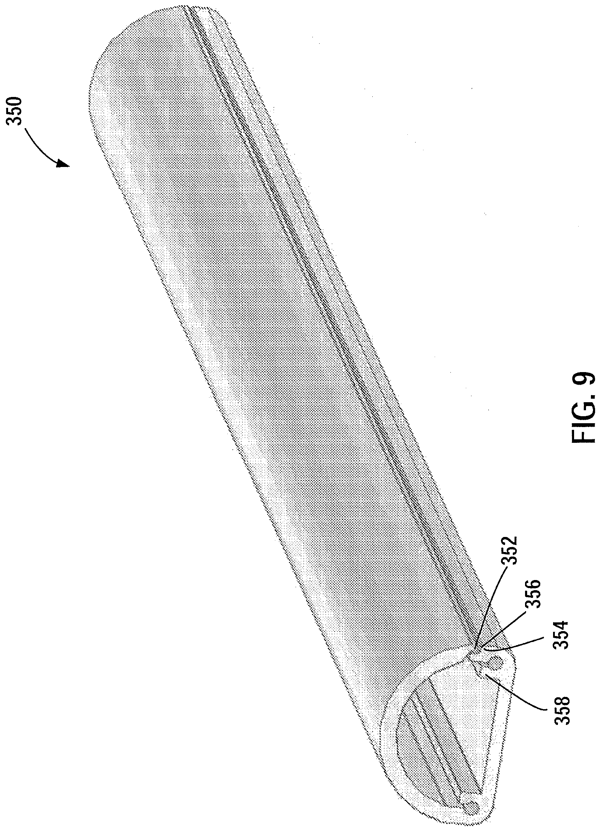

Figure 9 is a perspective view of a diffuser 350 that can be utilized to provide an even light and prevent hot spots by suitably locating a top portion of the diffuser 350 away from LEDs 500 of the unit. The diffuser may be constructed with a gap 356 on one side formed by a meeting of a top edge 352 and bottom edge 354 on one side of the diffuser 350. The diffuser may have an inner protrusion 358 that forms a portion of a wall for holding the reinforcing rod.

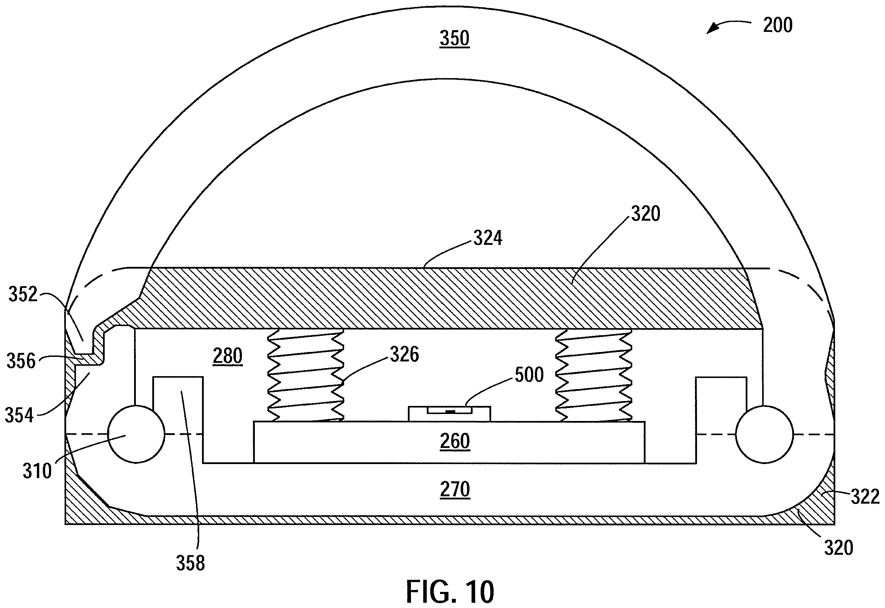

Figure 10 is a cross-sectional view of the embodiment shown in Figure 8A, and shows the relationship between portions of the end cap 320 with respect to the diffuser 350 and the flexible PCB 260 with LED 500 mounted on it. As can be seen in Figure 10, the main cavity of the unit is filled with the flex encapsulent 280. Also shown are the reinforcing rods 310. These rods 310 extend longitudinally down the length of the LED module assembly 200. In an embodiment, these rods 310 are made of a conductive metal that, in addition to providing a strengthening reinforcement, may provide grounding and possibly heat sinking functions. They also help protect the flexible PCB 260 from damage, since the reinforcing rods 310 would absorb most of the bending or tensile forces in the unit 200. Metallic rods 310 can be made of steel if strength properties are most important, copper if conductive properties are most important, or any other metal that has desirable characteristics. The rods can provide a ground for high voltage AC applications for additional safety and for electrostatic discharge (ESD) protection.

However, other materials can be used, and these materials may have similar characteristics to metal, or can have different characteristics. For example, for cost and other reasons (stress characteristics, etc.), nylon rods 310 could be used. However, the conductive nature of the rods 310 is lost when the material is nylon or other non-conducting material. Referring back to Figure 8C, the rods 310 may be extended from the end cap, and a connecting loop 315 can join the two. When the rods 310 are made of a conductive material, this loop 315 can then serve to better ground the unit by linking these together. When the loop 315 is nonconductive, it can at least serve as a convenient mechanism for fastening.

Also, although a circular cross-section shape is shown, any cross sectional shape including rectangular, oblong, etc. may be used. Also, as can be seen in the cross sectional view, the top of the inner protrusions 358 are higher than, and the rod 310 is higher than or level with the PCB 260 and LED 500, thus providing additional shielding/protection, particularly cut protection. The rod 310 also allows the unit 200 to form naturally inherent catenary curves when bending corners and permits it to span gaps without structural reinforcements.

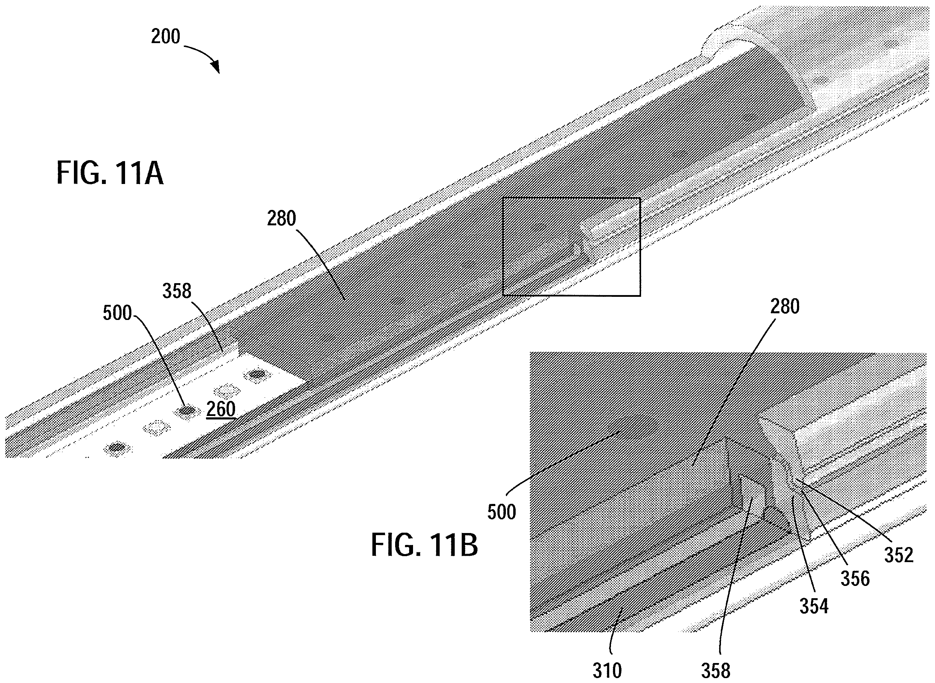

Figures 11A and 11B are perspective cut-away views of the assembly 200. The interface can be seen particularly well in Figure 11B where the gap 356 formed by the top 352 and bottom 354 edges is shown in relation to the flex encapsulent 280, and the construction of the diffuser 350 holding in the rods 310. The gap 356 permits the encapsulate 280 to be added by spreading the diffuser 350 open at the gap. The diffuser material, which is resilient, can then reform back into its relatively closed (optionally, but not necessarily, sealed) configuration.

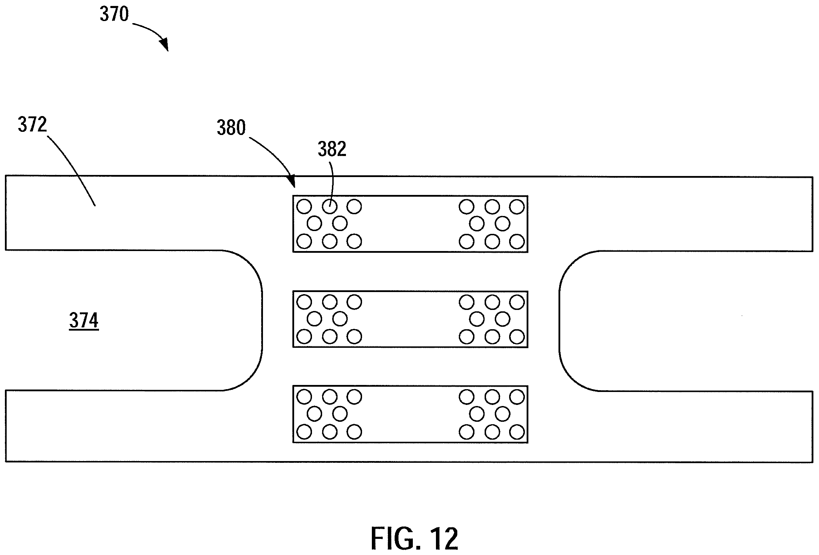

Figure 12 is a plan view of a flexible connector 370 that can be used to join together two or more assemblies 200. The connector 370 is flat and relatively thin, and may be made out of metal, plastic, nylon, or any material that provides flexibility while maintaining some supportive strength that allows two connected units to bend to some degree. On each end, the connector 370 has a pair of legs 372 having in between them a U-shaped cutout region 374. The central portion constitutes an electrical connection region 380. In Figure 12, the electrical connection region is broken down into three sub-regions (not labeled), which each constitute holes for inserting wires or a plug or pin connections. The legs 372 may be designed protrude into a bottom part of the diffuser 350 or into bottom portions of the flex module 250 itself.

The unit may further comprise a ground fault circuit interrupt (GFCI) as well as surge suppression. The GFCI may be implemented as a small front end PCB module that supports multiple lengths of lighting units 200. Additionally, surge/spike and ESD protection can be provided, possible on the same PCB or front end module. A separate power factor correction (PFC) and/or harmonic filter can be provided as well.

The system or systems described herein may be implemented on any form of computer or computers and the components may be implemented as dedicated applications or in client-server architectures, including a web-based architecture, and can include functional programs, codes, and code segments. Any of the computers may comprise a processor, a memory for storing program data and executing it, a permanent storage such as a disk drive, a communications port for handling communications with external devices, and user interface devices, including a display, keyboard, mouse, etc. When software modules are involved, these software modules may be stored as program instructions or computer readable codes executable on the processor on a computer-readable media such as read-only memory (ROM), random-access memory (RAM), CD-ROMs, magnetic tapes, floppy disks, and optical data storage devices. The computer readable recording medium can also be distributed over network coupled computer systems so that the computer readable code is stored and executed in a distributed fashion. This media is readable by the computer, stored in the memory, and executed by the processor.

For the purposes of promoting an understanding of the principles of the invention, reference has been made to the preferred embodiments illustrated in the drawings, and specific language has been used to describe these embodiments. However, no limitation of the scope of the invention is intended by this specific language, and the invention should be construed to encompass all embodiments that would normally occur to one of ordinary skill in the art.

The embodiments herein may be described in terms of functional block components and various processing steps. Such functional blocks may be realized by any number of hardware and/or software components that perform the specified functions. For example, the described embodiments may employ various integrated circuit components, e.g., memory elements, processing elements, logic elements, look-up tables, and the like, which may carry out a variety of functions under the control of one or more microprocessors or other control devices. Similarly, where the elements of the described embodiments are implemented using software programming or software elements the invention may be implemented with any programming or scripting language such as C, C++, Java, assembler, or the like, with the various algorithms being implemented with any combination of data structures, objects, processes, routines or other programming elements. Functional aspects may be implemented in algorithms that execute on one or more processors. Furthermore, the embodiments of the invention could employ any number of conventional techniques for electronics configuration, signal processing and/or control, data processing and the like. The words "mechanism" and "element" are used broadly and are not limited to mechanical or physical embodiments, but can include software routines in conjunction with processors, etc.

The particular implementations shown and described herein are illustrative examples of the invention and are not intended to otherwise limit the scope of the invention in any way. For the sake of brevity, conventional electronics, control systems, software development and other functional aspects of the systems (and components of the individual operating components of the systems) may not be described in detail. Furthermore, the connecting lines, or connectors shown in the various figures presented are intended to represent exemplary functional relationships and/or physical or logical couplings between the various elements. It should be noted that many alternative or additional functional relationships, physical connections or logical connections may be present in a practical device. Moreover, no item or component is essential to the practice of the invention unless the element is specifically described as "essential" or "critical".

The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings. Expressions such as "at least one of," when preceding a list of elements, modify the entire list of elements and do not modify the individual elements of the list.

The use of the terms "a" and "an" and "the" and similar referents in the context of describing the invention (especially in the context of the following claims) should be construed to cover both the singular and the plural. Furthermore, recitation of ranges of values herein are merely intended to serve as a shorthand method of referring individually to each separate value falling within the range, unless otherwise indicated herein, and each separate value is incorporated into the specification as if it were individually recited herein. Finally, the steps of all methods described herein are performable in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. Numerous modifications and adaptations will be readily apparent to those skilled in this art without departing from the scope of the invention as claimed.

### TABLE OF REFERENCE CHARACTERS

- 200: flex LED module assembly
- 250: flex LED module
- 260: flexible PCB
- 265: flexible PCB traces
- 270: flex LED module housing
- 275: flexible housing protrusions
- 280: flex encapsulant
- 310: reinforcing rod
- 315: connecting loop
- 320: end cap
- 322: end cap bottom
- 324: end cap top
- 326: fastener / screw
- 328: terminating silicone
- 350: diffuser
- 352: top edge
- 354: bottom edge
- 356: gap
- 358: inner protrusion
- 370: flexible connector
- 372: leg
- 374: U-shaped cutout
- 380: electrical connection region
- 382: holes
- 500: LED unit
- 505: housing
- 507: housing cavity
- 508: housing cavity wall
- 509: housing cavity floor
- 510: LED unit connector
- 520: LED unit encapsulant
- 525: LED unit top surface (see also S1)
- 530: LED
- 535: LED internal connector
- 600: lanyard
- Px: phosphorous particles
- Rx: light rays
- S1: LED unit top surface (see also 525)
- S2: flex encapsulant surface

## Claims

1. A flexible LED lighting element (250), comprising:
a flexible U-shaped housing (270) comprising arms;
a flexible printed circuit board (PCB) (260), comprising:
an LED (530) lighting unit (500), wherein the LED lighting unit (500) comprises:
a unit U-shaped housing (505);
an LED (530) mounted to a bottom surface of the unit U-shaped housing (505);
an LED unit encapsulent (520) that:
covers the LED (530);
fills the unit U-shaped housing (505); and
contains embedded phosphor particles (Px) of different colors; and
an LED unit connector (510);
a flexible diffuser (350) having a top arched portion above the LED (530); and
a stiffening rod that extends longitudinally through the flexible LED element (250), wherein the stiffening rod is at least two stiffening rod elements (310); wherein the diffuser (350) has a single edge opening (356) and is comprised of a memory shape material that is biased in a closed position.

2. The flexible LED element according to claim 1, further comprising an end loop (315) that joints one end of each of the stiffening rod elements (310).

3. The flexible LED element according to claim 1 or claim 2, wherein a top of the stiffening rod (310) is higher than or level with a top of the flexible PCB (260) and LED (530).

4. The flexible LED element according to any of claims 1 to 3, wherein the stiffening rod (310) is conductive.

5. The flexible LED element according to claim 4, wherein the stiffening rod (310) is steel.

6. The flexible LED element according to claim 4, wherein the stiffening rod (310) is grounded.

7. The flexible LED element according to any of claims 1 to 6, further comprising an encapsulent-filled endcap (320).

## Patentansprüche

1. Flexibles LED-Beleuchtungselement (250), Folgendes umfassend:
ein flexibles, U-förmiges Gehäuse (270), das Arme umfasst;
eine flexible Leiterplatte (PCB) (260), die Folgendes umfasst:
eine LED- (530) Beleuchtungseinheit (500), wobei die LED-Beleuchtungseinheit (500) Folgendes umfasst:
ein U-förmiges Gehäuse (505) der Einheit;
eine LED (530), die auf einer unteren Fläche des U-förmigen Gehäuses (505) der Einheit montiert ist;
ein Vergussmaterial (520) der LED-Einheit, das:
die LED (530) abdeckt;
das U-förmige Gehäuse (505) der Einheit ausfüllt; und
eingebettete Phosphorteilchen (Px) verschiedener Farben enthält; und
einen Verbinder (510) der LED-Einheit;
einen flexiblen Diffuser (350) mit einem oberen gewölbten Abschnitt oberhalb der LED (530); und
eine Versteifungsstange, die sich in Längsrichtung durch das flexible LED-Element (250) erstreckt, wobei die Versteifungsstange wenigstens zwei Versteifungsstangenelemente (310) aufweist; wobei der Diffuser (350) eine einzige Randöffnung (356) aufweist und aus einem Formgedächtnismaterial besteht, das in einer geschlossenen Position vorgespannt ist.

2. Flexibles LED-Beleuchtungselement nach Anspruch 1, ferner eine Endschleife (315) umfassend, die ein Ende jedes der Versteifungsstangenelemente (310) verbindet.

3. Flexibles LED-Beleuchtungselement nach Anspruch 1 oder 2, wobei eine Oberseite der Versteifungsstange (310) höher als oder auf gleicher Höhe mit einer Oberseite der flexiblen PCB (260) und der LED (530) ist.

4. Flexibles LED-Element nach einem der Ansprüche 1 bis 3, wobei die Versteifungsstange (310) leitfähig ist.

5. Flexibles LED-Element nach Anspruch 4, wobei die Versteifungsstange (310) aus Stahl ist.

6. Flexibles LED-Element nach Anspruch 4, wobei die Versteifungsstange (310) geerdet ist.

7. Flexibles LED-Element nach einem der Ansprüche 1 bis 6, ferner eine mit Vergussmaterial gefüllt Endkappe (320) umfassend.

## Revendications

1. Élément d'éclairage DEL flexible (250), comprenant :
un logement en forme de U flexible (270) comprenant des bras ;
une carte de circuit imprimé flexible (PCB) (260), comprenant :
une unité d'éclairage (500) DEL (530), l'unité d'éclairage (500) DEL comprenant :
un logement en forme de U unitaire (505) ;
une DEL (530) montée sur une surface de partie inférieure du logement en forme de U unitaire ;
un encapsuleur d'unité de DEL (520) qui :
recouvre la DEL (530) ;
remplit le logement en forme de U unitaire (505) ; et
contient des particules de phosphore incluses (Px) de différentes couleurs ; et
un connecteur d'unité de DEL (510) ;
un diffuseur flexible (350) ayant une partie arquée à la partie inférieure au-dessus de la DEL (530) ; et
une tige de raidissement qui s'étend longitudinalement à travers l'élément de DEL flexible (250), la tige de raidissement étant au moins deux éléments de tige de raidissement (310) ; le diffuseur (350) ayant une simple ouverture de bord (356) et étant composé d'un matériau à mémoire de forme qui est biaisé dans une position fermée.

2. Élément de DEL flexible selon la revendication 1, comprenant en outre une boucle d'extrémité (315) qui joint une extrémité de chacun des éléments de tige de raidissement (310).

3. Élément de DEL flexible selon la revendication 1 ou la revendication 2, une partie supérieure de la tige de raidissement (310) étant plus élevée qu'une partie supérieure de la PCB flexible (260) et de la DEL (530) ou de niveau avec ces éléments.

4. Élément de DEL flexible selon l'une quelconque des revendications 1 à 3, la tige de raidissement (310) étant conductrice.

5. Élément de DEL flexible selon la revendication 4, la tige de raidissement (310) étant en acier.

6. Élément de DEL flexible selon la revendication 4, la tige de raidissement (310) étant mise à la terre.

7. Élément flexible de DEL selon l'une quelconque des revendications 1 à 6, comprenant en outre une coiffe d'extrémité remplie d'encapsuleur (320).
